Europäisches Patentamt

(19) European Patent Office

Office européen des brevets

(11) Numéro de publication : **0 026 686**

**B1**

(12) **FASCICULE DE BREVET EUROPÉEN**

(45) Date de publication du fascicule du brevet :
11.05.83

(51) Int. Cl.³ : **H 01 L 21/31**, H 01 L 29/78

(21) Numéro de dépôt : **80401252.4**

(22) Date de dépôt : **02.09.80**

(54) **Procédé de fabrication de couches de silicium polycristallin localisées sur des zones recouvertes de silice d'une plaquette de silicium, et application à la fabrication d'un transistor MOS non plan auto-aligné.**

(30) Priorité : 18.09.79 FR 7923242

(43) Date de publication de la demande :
08.04.81 Bulletin 81/14

(45) Mention de la délivrance du brevet :
11.05.83 Bulletin 83/19

(84) Etats contractants désignés :
DE FR GB IT NL

(56) Documents cités :
FR A 2 340 619
US A 3 640 806
US A 3 954 523
US A 4 092 445
US A 4 116 720
US A 4 167 745

(73) Titulaire : **THOMSON-CSF**
**173, Boulevard Haussmann**
**F-75379 Paris Cedex 08 (FR)**

(72) Inventeur : **Tonnel, Eugène**
**"THOMSON-CFS" SCPI 173, bld Haussmann**
**F-75360 Paris Cedex 08 (FR)**

(74) Mandataire : **de Beaumont, Michel et al**
**THOMSON-CSF SCPI 173, Bld Haussmann**
**F-75379 Paris Cedex 08 (FR)**

## Procédé de fabrication de couches de silicium polycristallin localisées sur des zones recouvertes de silice d'une plaquette de silicium, et application à la fabrication d'un transistor MOS non plan auto-aligné

La présente invention concerne un procédé de formation de couches de silicium polycristallin localisées sur des zones recouvertes de silice d'une plaquette de silicium, et une application particulière de ce procédé à la fabrication d'un MOS non plan auto-aligné.

On entend dans la présente description par « MOS non plan » un dispositif à effet de champ comprenant notamment les types couramment appelés transistors V-MOS et transistors U-MOS. L'abréviation « MOS » désigne les initiales des mots métal-oxyde-semiconducteur. « V-MOS » désigne un MOS à rainures en V et « U-MOS » désigne un MOS à rainures en U. Ces transistors V-MOS et U-MOS ont des fonctionnements verticaux ou sensiblement verticaux et peuvent notamment être utilisés pour des applications dans lesquelles des tensions relativement élevées sont appliquées et des courants relativement importants circulent.

De façon générale, dans les techniques de fabrication de composants semiconducteurs, et plus particulièrement dans les techniques de fabrication de circuits intégrés, on vise à une miniaturisation aussi grande que possible des divers éléments. Pour atteindre cette miniaturisation, on fait couramment usage de procédés dits d'auto-alignement, c'est-à-dire de procédés évitant d'utiliser des masques successifs et permettant à partir d'un masque initial d'effectuer plusieurs opérations successives qui s'alignent de façon automatique sur les motifs définis par le masque initial.

Parmi ces techniques d'auto-alignement, un objet de la présente invention est de prévoir un procédé pour aligner automatiquement la formation de couches de silicium polycristallin sur des couches d'oxyde de silicium préalablement formées à la surface d'une plaquette de silicium monocristallin.

Un autre objet de la présente invention est de prévoir l'application de ce procédé à la fabrication de structures telles que des transistors MOS non plans.

Ainsi, le procédé selon la présente invention de formation de couches de silicium polycristallin sur des zones recouvertes de silice d'une plaquette de silicium comprend les étapes consistant à :

— déposer uniformément une couche de silicium polycristallin sur une face de la plaquette ;

— anodiser la plaquette en l'immergeant dans un bain acide et en faisant circuler un courant dans celle-ci entre sa face arrière et une électrode placée dans le bain.

Le bain acide peut être une solution aqueuse d'acide fluorhydrique à faible concentration. L'anodisation peut être effectuée en présence d'une illumination. L'anodisation est effectuée à une densité de courant plus ou moins élevée, en fonction du bain choisi et d'une éventuelle illumination pour, ou bien, transformer le silicium polycristallin en silicium poreux dans les zones non recouvertes d'oxyde de silicium, ou bien, éliminer complètement la couche de silicium polycristallin dans ces zones. (Une étude de la dissolution anodique d'une couche de silicium de type P ou N en fonction de la distribution de potentiel qui y règne a été faite dans le brevet français 2 070 873).

Selon la présente invention, une application du procédé ci-dessus à la fabrication d'une structure de transistor MOS non plan à partir d'une plaquette de silicium comprend les étapes successives suivantes : former dans la plaquette des sillons revêtus d'une couche d'oxyde de silicium ; mettre en œuvre le procédé ci-dessus ; procéder à des étapes successives d'implantations, diffusions et masquages en utilisant le silicium polycristallin formé sur la silice comme limite de masque d'implantation de part et d'autre des sillons pour obtenir une structure classique de MOS non plan ; et procéder aux métallisations et connexions usuelles.

On notera que ce procédé diffère nettement des procédés habituels de fabrication de transistors MOS non plans dans lesquels le sillon était formé après formation par implantation ou diffusion des couches de formation de canal et de source. Ces procédés ne permettaient pas un auto-alignement de la formation de la couche de grille en silicium polycristallin sur le sillon.

Ces objets, caractéristiques et avantages ainsi que d'autres de la présente invention seront exposés en détail dans la description suivante de modes de réalisation particuliers faite en relation avec les figures jointes parmi lesquelles :

Les Figures 1 et 2 illustrent en coupe deux étapes du procédé d'auto-alignement de silicium polycristallin sur des couches de silice localisées sur une plaquette de silicium ;

La Figure 3 représente, selon une vue en perspective coupée, une structure de transistor V-MOS de puissance que l'on vise à réaliser par le procédé selon la présente invention ;

Les Figures 4 à 12 sont des vues en coupe schématiques, selon un plan perpendiculaire au plan des sillons de la Fig. 3, destinées à illustrer des étapes successives de fabrication du dispositif de la Fig. 3 ;

Les Figures 13 à 16 sont des vues en coupe, selon un plan parallèle à la direction des sillons de la structure de la Fig. 3; à diverses étapes de fabrication ; et

Les Figures 17 à 19 illustrent un mode de réalisation particulier des étapes précédemment illustrées dans les Fig. 10 et 11.

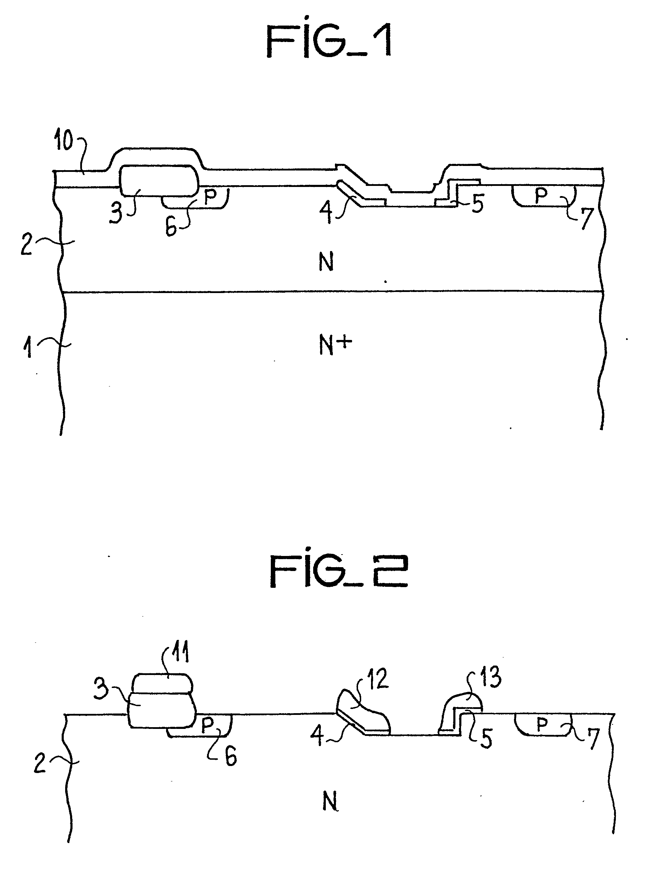

La Fig. 1 représente une plaquette de silicium comportant une zone 1 de type $N^+$ revêtue d'une zone 2 de type N. Sur la surface de cette couche 2 de type N sont formées des zones localisées de silice ($SiO_2$) 3, 4 et 5 par tout procédé. A titre d'exemple, on a représenté la zone de silice 3 comme une couche épaisse de silice thermique, et les couches 4 et 5 comme des couches relativement minces de silice thermique ou pyrolytique déposées en des emplacements où la surface de la couche 2 est non plane. La couche de silice 4 est déposée à un emplacement où la surface présente un flanc incliné et la couche 5 à un emplacement où la surface présente un échelon ou marche d'escalier. On a également représenté sur la Fig. 1 des zones de type P localisées 6 et 7 résultant par exemple de diffusions ou d'implantations dans la couche 2. La zone de type P 6 est représentée comme partiellement revêtue de la couche de silice 3 alors que la couche 7 de type P est représentée comme n'étant pas revêtue d'une couche de silice.

Ainsi, pour atteindre l'objet de la présente invention, à savoir recouvrir de silicium polycristallin seulement les zones d'oxyde 3, 4 et 5 d'une structure comprenant les couches et zones 1 à 7 illustrées en Fig. 1, on procède aux étapes suivantes :

Dans une première étape, on dépose uniformément une couche de silicium polycristallin 10 non dopé.

Dans une deuxième étape, on fait baigner la plaquette de silicium dans un bain acide, une électrode étant solidaire de la face arrière de la plaquette (face N$^+$) et l'autre électrode étant par exemple une électrode de platine disposée dans le bain. L'électrode sur la face arrière est par exemple constituée d'une ventouse aspirante maintenant la plaquette et la protégeant d'un contact avec le bain.

Par ce procédé, on obtient, selon le courant traversant la plaquette une transformation du silicium polycristallin ou bien en une substance qui se dissout dans le bain acide ou bien en silicium poreux et ceci dans les zones non recouvertes d'oxyde de la plaquette de type N. Un problème particulier se pose dans le cas où il existe des zones P telles que les zones 6 et 7 sur la région N. En effet, le courant a alors tendance à moins passer par ces zones en raison de l'effet de diodes en inverse des jonctions NP. Pour résoudre cette difficulté, on éclaire fortement la face avant de la plaquette et il se produit ainsi une génération de porteurs au niveau de la jonction qui pallie les effets redresseurs de cette jonction.

A titre de premier exemple numérique : on a placé une plaquette revêtue d'une couche de silicium polycristallin de 0,5 micron dans un bain de FH à 2 % et on a ainsi obtenu une couche de silicium poreux en 3 minutes avec une densité de courant de 5mA/cm$^2$. Cette couche de silicium poreux peut ensuite être oxydée, ce qui a été obtenu dans l'exemple donné par traitement sous vapeur d'eau à 970 °C en 15 minutes.

Toutes choses égales d'ailleurs (solution aqueuse 10 à 2 % de FH et épaisseur de silicium polycristallin de 0,5 micron) on a obtenu une dissolution anodique du silicium polycristallin en 15 secondes d'attaque avec une densité de courant de 100 mA/cm$^2$.

Des essais ont également été réalisés en faisant varier la concentration du bain, et avec un bain de FH à 15 %, on a obtenu des résultats satisfaisants quoique plus lents. Pour accélérer le processus dans le cas où il n'existe pas de jonction NP et pour permettre un processus satisfaisant dans le cas où il existe une jonction NP, on a procédé à un éclairage de la face avant de la plaquette.

Les résultats d'expérience énoncés précédemment montrent que, en choisissant convenablement le courant d'anodisation, on peut ou bien obtenir la structure illustrée en Fig. 2 dans laquelle des zones de silicium polycristallin 11, 12 et 13 sont déposées sur les zones préalablement oxydées de la plaquette, les autres zones étant exemptes de tout dépôt de silicium polycristallin, ou bien obtenir une structure telle que celle représentée en Fig. 2 mais dans laquelle les régions complémentaires des régions 11, 12 et 13 sont occupées par un dépôt de silicium poreux. Ce silicium poreux peut être transformé en oxyde de silicium par un traitement thermique oxydant.

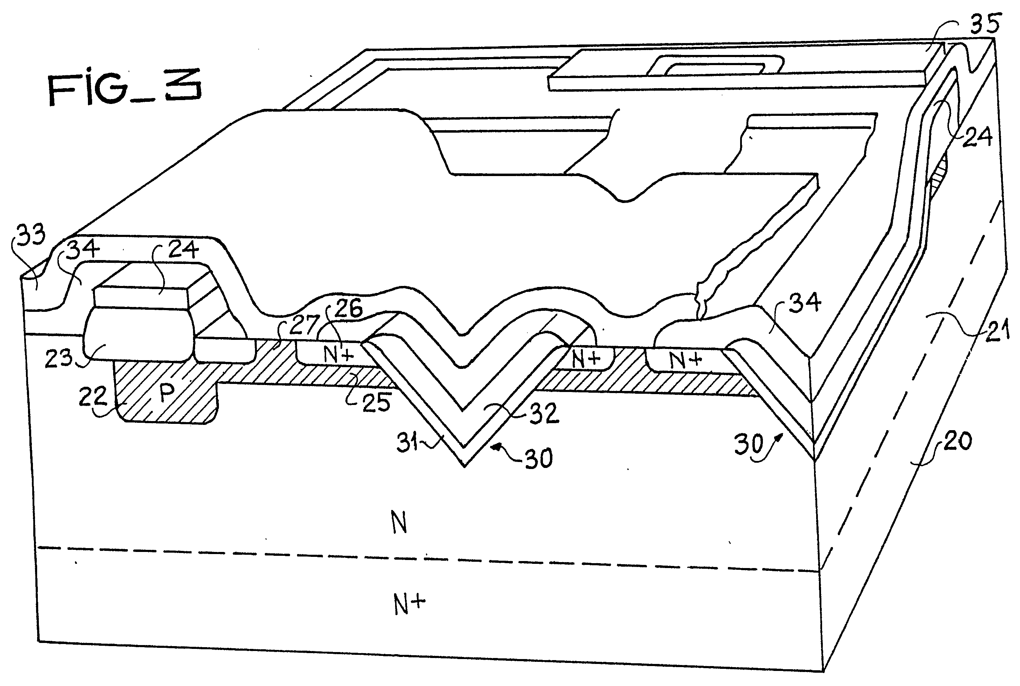

La Fig. 3 représente une structure de transistor MOS de type V-MOS à fonctionnement vertical et à plusieurs sillons. Cette structure comprend une couche 20 de type N$^+$ ou face arrière du dispositif sur laquelle est déposée une couche épitaxiée 20 de type N. La zone superficielle périphérique de cette structure comprend une diffusion relativement profonde 22 de type P revêtue au moins partiellement d'une couche d'oxyde épaisse 23. Cette couche périphérique 23 est elle-même revêtue d'une couche périphérique, ou en anneau, de silicium polycristallin 24. Dans les limites déterminées par l'anneau 22 de type P est formée une couche 25 de même type P mais de moins grande profondeur. Au-dessus de cette couche de type P25 se présente une couche 26 de type N$^+$, la couche 25 de type P remontant en certains emplacements 27 vers la surface de la plaquette. Dans cette structure sont formés un ou plusieurs sillons en V parallèles 30 qui pénètrent dans la plaquette et traversent la couche P25 pour atteindre la couche N 21. Le sillon est revêtu d'une couche d'oxyde de silicium 31, elle-même revêtue d'une électrode de grille 32 en silicium polycristallin qui rejoint la couche de silicium polycristallin en anneau 24. Une couche métallique 33 servant d'électrode de source est en contact avec la couche de source 26 de type N$^+$ et avec les zones remontantes 27 de la couche de formation de canal 25 de type P. Cette couche métallique 33, par exemple en aluminium, est isolée par une couche diélectrique 34 des zones de silicium polycristallin 24 et 32 constituant le contact et l'électrode de grille. Ce contact de grille est par exemple repris par une métallisation 35 disposée le long de l'un au moins des bords de la couche de silicium polycristallin 24.

Les Fig. 4 à 12 illustrent le procédé de fabrication selon la présente invention d'une structure telle que celle de la Fig. 3. Dans les Fig. 4 à 12, on a représenté autant que faire se peut de mêmes éléments par de mêmes références. On a également choisi des références identiques à celles de la Fig. 3 quand cela était possible, même dans le cas où les couches ou zones correspondant à des couches ou zones de la Fig. 3 se trouvaient à des étapes où elles n'avaient pas encore leur configuration définitive.

La Fig. 4 représente le dispositif après la diffusion dans la couche épitaxiée N 21 sur le substrat N⁺20 de l'anneau de garde P⁺22. On a figuré également à ce niveau une couche de nitrure de silicium 40 et des ouvertures 41 qui y sont pratiquées à la périphérie. La couche de nitrure 40 n'est pas déposée généralement à même le silicium mais sur une couche d'oxyde mince (non représentée) qui permet de limiter les contraintes et d'arrêter l'attaque lors de la gravure de la couche de nitrure.

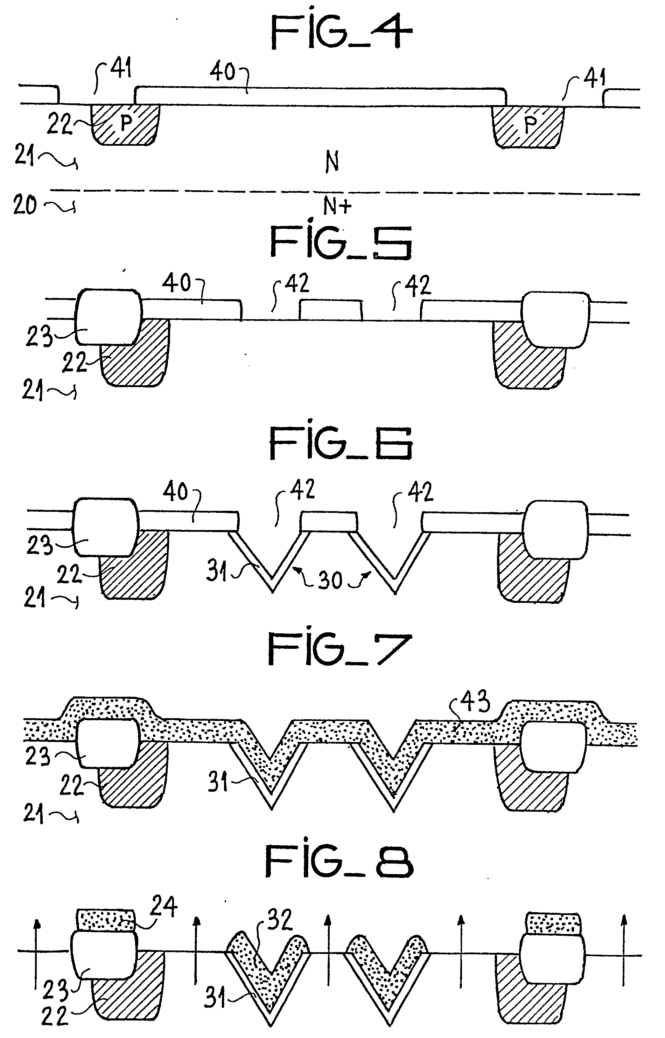

Dans l'étape illustrée en Fig. 5, le dispositif subit un traitement oxydant qui a simultanément approfondi l'anneau de garde P⁺22 et protège la partie périphérique de la jonction sous une couche 23 d'oxyde épais (1μ) dite oxyde de champ. La croissance de cette couche d'oxyde 23 est par ailleurs interdite dans les régions protégées par le nitrure. Après ce recuit, on grave la couche de nitrure de façon à définir des ouvertures 42 dans lesquelles seront creusés les sillons (au nombre de deux dans l'exemple illustré).

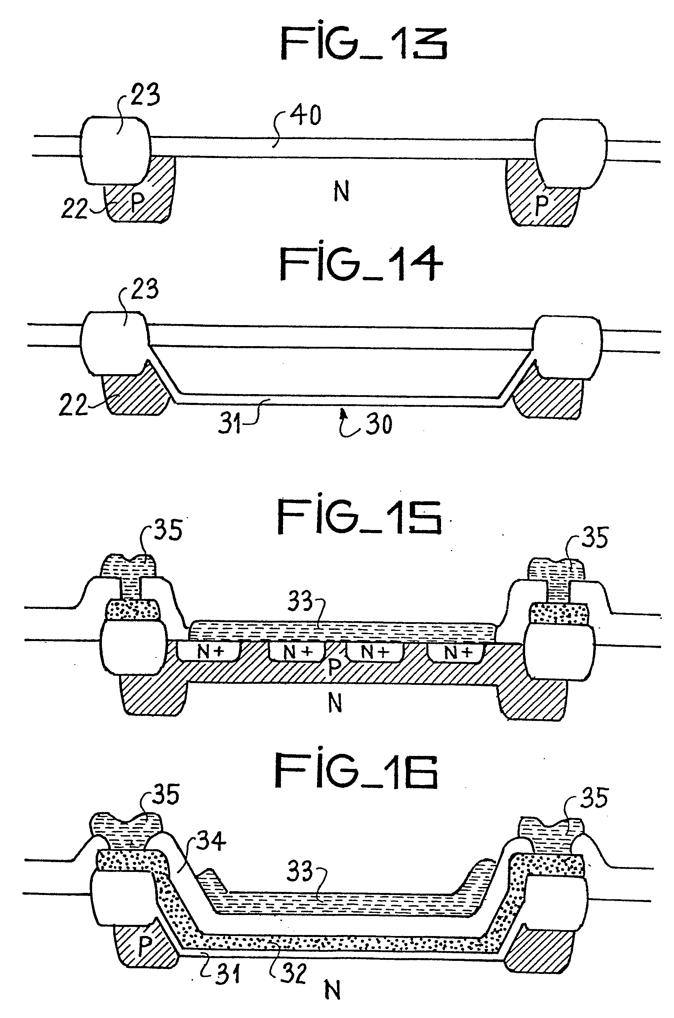

La Fig. 6, qui représente comme l'ensemble des Fig. 4 à 12 une vue en coupe selon un plan perpendiculaire à la direction des sillons, illustre l'étape de formation des sillons 30, puis d'oxydation thermique pour former une couche d'oxyde 31 sur les faces de ces sillons, cette oxydation thermique étant limitée aux zones creusées non recouvertes de nitrure de silicium. Pour mieux comprendre la façon dont sont limitées longitudinalement les sillons, on pourra se référer aux Fig. 13 et 14 qui représentent des vues en coupe selon des plans perpendiculaires à la face principale de la plaquette et parallèles à la direction des sillons, la coupe de la Fig. 13 étant effectuée en dehors des sillons et la coupe de la Fig. 14 selon l'axe d'un sillon. De façon classique, les parois des sillons correspondent à des plans (1, 1, 1) qui limitent l'attaque anisotrope et se situent respectivement dans des régions N latéralement et dans l'anneau de garde 22 longitudinalement en bout de sillon.

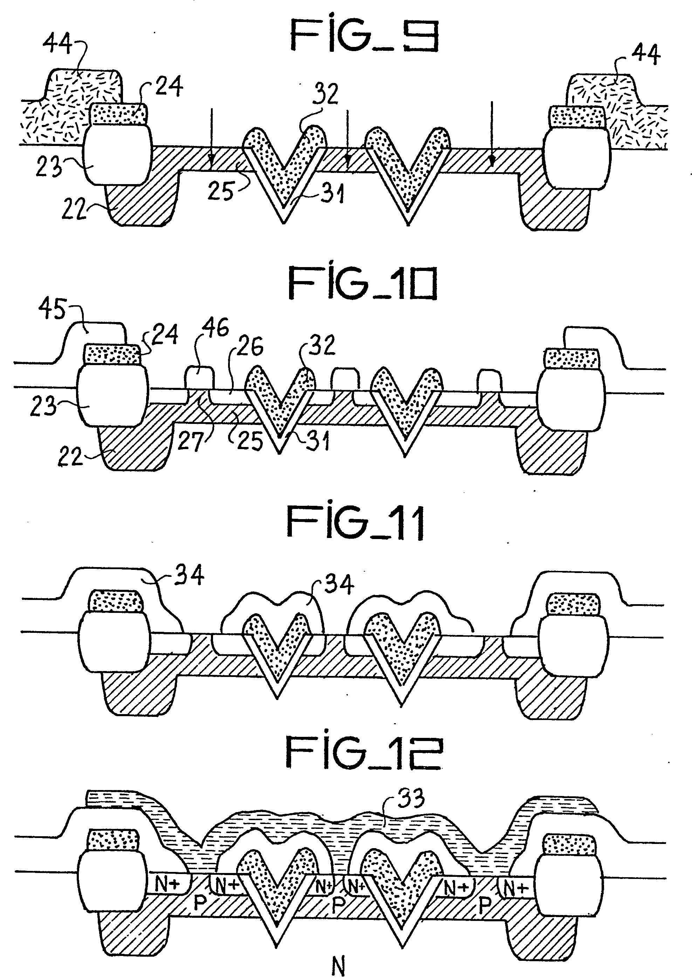

Les Fig. 7 et 8 illustrent deux étapes suivantes du procédé qui correspondent au procédé par anodisation de dépôt de silicium polycristallin localisé sur les couches de silice, précédemment décrit en relation avec les Fig. 1 et 2.

Comme le représente la Fig. 7, la couche de nitrure 40 éliminée, on dépose une couche de silicium polycristallin 43. Cette couche 43 repose sur le silicium dans les régions qui étaient protégées par la couche de nitrure et sur de l'oxyde à la périphérie et dans les sillons. Si une couche mince (500 Å) de silice était initialement formée avant le dépôt de la couche de nitrure 40, cette couche sera attaquée avant le dépôt de la couche de silicium polycristallin. Cette attaque est effectuée, par exemple, sans masquage en jouant sur les différences d'épaisseur des couches d'oxyde formées dans le sillon et initialement.

La Fig. 8 représente l'étape de l'alignement de l'électrode de grille sur le sillon, elle est obtenue par anodisation de la couche de silicium polycristallin 43 au niveau des régions déposées à même le silicium. L'anodisation du silicium polycristallin est par exemple réalisée sous forte illumination dans une solution de FH à 2 % dans l'eau entre une électrode en platine, formant la cathode, et la plaquette de silicium qui sert d'anode. Le contact est pris sur la face arrière métallisée de la plaquette, maintenue par aspiration ou par serrage dans un support contre un joint en silastène. En contrôlant la densité de courant utilisée et la durée d'anodisation, on peut soit attaquer le silicium polycristallin comme représenté sur la figure, soit transformer le silicium en silicium poreux au niveau des régions en contact avec le silicium monocristallin. Dans le cas où du silicium poreux est obtenu, une oxydation thermique ultérieure le transformera en une couche d'oxyde poreux utilisé dans la suite du procédé.

La Fig. 9 représente la structure après implantation des régions P 25 où sera formé le canal. Une implantation de bore, par exemple, est effectuée, soit à travers l'oxyde poreux formé précédemment, soit sur le silicium mis à nu par l'attaque anodique précédente. Cette implantation est masquée par une couche de résine 44 à la périphérie de l'élément et par les couches de silice et de silicium polycristallin 23-24 et 31-32. Il est possible avec un masque adéquat de réaliser avec la même implantation une série d'anneaux de garde supplémentaires disjoints du premier, de façon à étaler le champ électrique à la périphérie de l'élément. Une dose de bore de l'ordre 10¹⁴at/cm² et une énergie de 80 KeV donnent de bons résultats, le recuit est effectué en atmosphère neutre et une couche d'oxyde est déposée au préalable dans le cas où le silicium était nu lors de l'implantation.

La Fig. 10 représente la gravure de la couche d'oxyde déposée précédemment pour laisser une zone d'oxyde périphérique 45 et des plots d'oxyde 46 destinés à assurer les remontées 27 de la couche 25 de type P, ainsi que la diffusion des régions N⁺26. Cette diffusion est conjointement masquée par les couches d'oxyde qui ont permis précédemment de délimiter l'anodisation du silicium polycristallin ; en particulier le dopant pénètre le long des flancs du sillon et compense une fraction de la région P diffusée précédemment.

La région qui, le long des flancs du sillon, demeurera P en profondeur et qui correspond au canal du transistor V-MOS obtenu, sera donc automatiquement alignée sur les arêtes formées par le sillon à la surface du dispositif.

Ce procédé permet donc, contrairement aux procédés classiques où l'on creuse les sillons après avoir effectué les diffusions, d'obtenir successivement l'alignement de l'électrode de grille sur les sillons, puis l'alignement des diffusions sur l'électrode elle-même. Ce procédé est rendu possible par l'oxydation localisée des sillons (Fig. 3) et par la protection que ces couches d'oxyde apportent lors de l'attaque anodique du silicium polycristallin.

Les Fig. 11 et 12 représentent des étapes classiques de dépôt et de gravure d'une couche d'isolement 34 située entre l'électrode de grille et les métallisations (Fig. 11), puis de dépôt et de gravure des métallisations (Fig. 12).

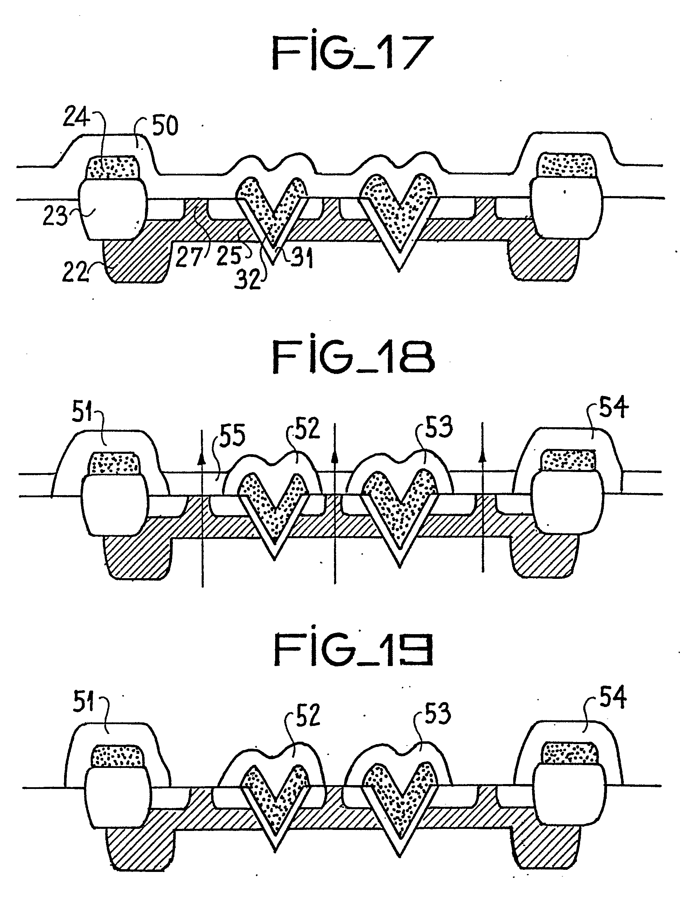

En Fig. 12, on peut voir la métallisation de source 33 et dans les Fig. 15 et 16 qui sont des vues en coupe longitudinales correspondant à l'étape terminale de la Fig. 12, la coupe longitudinale de la Fig. 15 étant effectuée entre deux sillons et la coupe longitudinale de la Fig. 16 dans un sillon, on peut voir la métallisation de source 33 et la métallisation de grille 35.

Le procédé décrit ci-dessus peut s'appliquer également avec un substrat d'orientation (110) au lieu de (100). Dans ce cas, les sillons présentent des flancs verticaux et il est alors possible de diminuer encore le pas de la structure interdigitée. L'oxydation localisée des flancs est toujours possible et le dépôt de la couche de silicium polycristallin peut même permettre pour des sillons étroits (2μ) et des conditions adéquates, un remplissage favorable de ces derniers. Dans ce cas, on obtient une structure de transistor à effet de champ plane et de très grandes transconductances par unité de surface (pas < 10μ) $g_m \simeq 1$ A/V/mm² ; pour ces transistors, la résistance de drain par unité de surface ne dépendant plus du pas de la structure grille/source mais seulement de l'épaisseur et de la résistivité de la couche épitaxiée, il est possible d'optimiser parfaitement l'élément et de tirer le maximum du silicium utilisé en obtenant simultanément des conductances et des transconductances élevées.

Dans l'exposé précédent, on n'a décrit que très brièvement en relation avec les Fig. 11 et 12 les étapes de formation des métallisations de contact. On notera que, pour ces métallisations également, on peut utiliser un procédé d'auto-alignement. Un tel procédé va être décrit et illustré en relation avec les Fig. 17 à 19.

Après l'étape illustrée en Fig. 10, au lieu de procéder à une oxydation partielle de la structure, comme cela était représenté en Fig. 11, on désoxyde complètement la surface des dispositifs et l'on y dépose une couche de nitrure de silicium 50 (Fig. 17). Dans l'étape illustrée en Fig. 18, on procède à une oxydation anodique de la couche de nitrure et ainsi le nitrure est transformé en oxyde de silicium dans les régions où il présente la moindre épaisseur, et où il ne repose pas sur une couche de silicium revêtue de silicium polycristallin. On obtient les régions 51, 52, 53 et 54 illustrées en Fig. 18 au-dessus des sillons et de l'anneau de garde, et une couche de silice 55 dans les emplacements complémentaires de la surface de la plaquette.

Comme le montre la Fig. 19, la couche d'oxyde 55 est ensuite enlevée. On notera à titre d'exemple, qu'avec une alimentation de 160 volts pouvant délivrer 70 milli-ampères dans un bain d'éthylène-glycol avec une solution de NO₃K à

4 g par litre et à température ambiante, on peut obtenir la transformation en silice d'une couche de Si₃N₄ d'une épaisseur de 600 Å, en limitant la tension à 100 volts pour tenir compte de la tenue en tension des régions d'oxyde minces existant par exemple au-dessus des sillons.

La présente invention n'est pas limitée aux modes de réalisation qui ont été explicitement décrits ci-dessus ; elle en inclut les diverses variantes et généralisations comprises dans le domaine des revendications ci-après.

## Revendications

1. Procédé de formation localisée de couches de silicium polycristallin sur des zones recouvertes de silice d'une plaquette de silicium, caractérisé en ce qu'il comprend les étapes suivantes :
— déposer uniformément une couche de silicium polycristallin (10) non dopé sur la face de la plaquette comportant les zones de silice, et
— anodiser la plaquette en l'immergeant dans un bain acide et en faisant circuler un courant dans celui-ci entre sa face arrière et une électrode placée dans le bain.

2. Procédé selon la revendication 1, caractérisé en ce que le bain acide est une solution aqueuse de 2 à 15 % d'acide fluorhydrique.

3. Procédé selon l'une des revendications 1 ou 2, caractérisé en ce que l'anodisation est effectuée en présence d'une illumination.

4. Procédé selon l'une quelconque des revendications 1 à 3, caractérisé en ce que l'anodisation est effectuée à faible densité de courant pour transformer, dans les zones non recouvertes d'oxyde (23), le silicium polycristallin en silicium poreux, cette couche de silicium poreux étant ensuite oxydée.

5. Application du procédé selon l'une quelconque des revendications 1 à 4 à la fabrication d'une structure de transistor MOS non plan à partir d'une plaquette de silicium, ce procédé de fabrication consistant à :
   a) former dans la plaquette des sillons (30) revêtus d'une couche d'oxyde de silicium (31) ; caractérisé en ce qu'il comprend en outre les étapes suivantes :
   b) mettre en œuvre le procédé selon l'une quelconque des revendications 1 à 4 ;
   c) procéder à des étapes d'implantations, diffusions et masquages successifs en utilisant le silicium polycristallin formé sur la silice comme limite de masque d'implantation de part et d'autre des sillons (30) pour obtenir une structure classique de transistor MOS non plan ; et
   d) procéder aux métallisations et connexions usuelles.

6. Procédé selon la revendication 5, caractérisé en ce que l'étape a) se décompose en les étapes suivantes :
— déposer une couche de nitrure de silicium (40) sur la plaquette ;
— ouvrir cette couche de nitrure (40) aux emplacements où l'on souhaite former les sillons ;

— attaquer la plaquette par un produit d'attaque anisotrope ;

— effectuer un traitement thermique pour oxyder la surface apparente des sillons.

7. Procédé selon l'une des revendications 5 ou 6, caractérisé en ce que, avant l'étape a), on forme dans la plaquette un anneau de garde (22) diffusé entourant le transistor MOS de type opposé à celui de la plaquette, cet anneau de garde (22) étant revêtu partiellement à sa périphérie externe d'une couche de silice (40), et en ce que, lors de l'étape b), on forme une couche de silicium polycristallin sur ladite couche en anneau de silice en même temps que l'on forme une couche de silicium polycristallin de grille au-dessus des sillons, ces deux couches de silicium polycristallin se rejoignant.

8. Procédé selon la revendication 6 caractérisé en ce que l'étape d) de formation de métallisation comprend les étapes consistant à :

— déposer uniformément une couche de nitrure de silicium (50) ;

— transformer en silice par anodisation les parties de la couche de nitrure (50), les moins épaisses reposant directement sur les emplacements de la plaquette où le semiconducteur était à nu avant le dépôt de nitrure ;

— enlever par attaque chimique la silice,

— déposer une couche de métallisation.

## Claims

1. A process for locally forming polycrystalline silicon layers on zones of a silicon plate which are covered with silica, characterized in that it comprises the steps of :

— uniformly depositing a non doped polycrystalline silicon layer (10) onto that face of the plate which is provided with said silica zones, and,

— anodizing the plate by immersing it in an acid bath and by passing a current through said bath between the rear face of the plate and an electrode placed in said bath.

2. A process according to claim 1, characterized in that said acid bath is a 2 to 15 % aqueous solution of hydrofluoric acid.

3. A process according to one of claims 1 or 2, characterized in that said anodizing step is carried out in the presence of an illumination.

4. A process according to any one of claims 1 to 3, characterized in that said step of anodizing is carried out with a low current density, so as to transform, in the zones non covered with oxide (23), the polycrystalline silicon into porous silicon, said porous silicon layer being then oxidized.

5. An application of the process according to any one of claims 1 to 4 to the manufacture of a non planar MOS transistor structure, starting from a silicon plate, comprising :

a) forming grooves (30) in said plate, which are covered with a silicon oxide layer (31) ;

characterized in that it further comprises the steps of :

b) carrying out the process according to any one of claims 1 to 4 ;

c) performing successive implantation, diffusion and masking steps while using the polycrystalline silicon formed on the silica as an implantation mask on either side of the grooves (30), so as to obtain a conventional non planar MOS transistor structure ; and

d) effecting the usual metallization and connecting steps.

6. A process according to claim 5, characterized in that said step a) comprises the steps of

— depositing a silicium nitride layer (40) on the plate ;

— opening said nitride layer (40) at the locations where said grooves are to be formed ;

— attacking said plate by an anisotrope etching product ;

— performing a heat treatment for oxidizing the exposed surface of the grooves.

7. A process according to any of claims 5 or 6, characterized in that prior to performing said step a), a diffused protecting ring (22) is formed, which surrounds the MOS transistor of the type opposed to that of the plate, said protecting ring (22) being covered partially at its outer periphery with a silica layer (40), and in that during the carrying out of step b) a polycrystalline silicon layer is formed on said annular silica layer, while simultaneously a polycrystalline silicon grid layer is formed above said grooves, in such a manner that said two polycrystalline silicon layers are in engagement with each other.

8. A process according to claim 6, characterized in that step d) of forming a metallization layer comprises :

— uniformly depositing a silicon nitride layer (50) ;

— transforming into silica, by anodizing the thinnest portions of the nitride layer (50) resting directly on those locations of the plate at which the semiconductor was bare prior to the depositing of the nitride ;

— removing the silica by chemical attack.

— depositing a metallization layer.

## Ansprüche

1. Verfahren zur Bildung von örtlichen polykristallinen Siliziumschichten auf mit Siliziumoxyd bedeckten Zonen einer Siliziumplatte, dadurch gekennzeichnet, dass es folgende Verfahrensschritte umfasst :

— Aufbringen einer einheitlichen Schicht von nicht dotiertem, polykristallinem Silizium (10) auf die mit den Siliziumoxydzonen versehenen Fläche der Platte, und

— Anodisieren der Platte durch Eintauchen derselben in ein Säurebad, wobei man durch dasselbe einen Strom zwischen ihrer hinteren Fläche und einer in dem Bad angeordneten Elektrode hindurchleitet.

2. Verfahren nach Anspruch 1, dadurch gekennzeichnet, dass das Säurebad aus einer wässerigen 2- bis 15-prozentigen Fluorwasserstofflösung besteht.

3. Verfahren nach einem der Ansprüche 1 oder 2, dadurch gekennzeichnet, dass das Anodisieren bei Anwesenheit einer Beleuchtung erfolgt.

4. Verfahren nach einem der Ansprüche 1 bis 3, dadurch gekennzeichnet, dass das Anodisieren mit geringer Stromstärke durchgeführt wird, um in den nicht mit Oxyd bedeckten Zonen (23) das polykristalline Silizium in poröses Silizium umzuwandeln, wobei diese poröse Siliziumschicht danach oxydiert wird.

5. Anwendung des Verfahrens nach einem der Ansprüche 1 bis 4 auf die Herstellung einer nicht ebenen MOS-Transistorstruktur, ausgehend von einer Siliziumplatte, mit folgenden Verfahrensschritten :

a) Erzeugung von mit einer Schicht von Siliziumoxyd (31) bedeckten Rillen (30) ; dadurch gekennzeichnet, dass ferner folgende Verfahrensschritte durchgeführt werden :

b) Durchführung des Verfahrens nach einem der Ansprüche 1 bis 4 ;

c) nacheinander erfolgendes Einpflanzen, Diffundieren und Maskieren unter Verwendung des auf dem Siliziumoxyd gebildeten polykristallinen Siliziums als Begrenzung der Einpflanzmaske auf beiden Seiten der Rillen (30), um eine herkömmliche nicht ebene MOS-Transistorstruktur zu erzielen ; und

d) Durchführung der üblichen Metallisations- und Anschlussverfahrensschritte.

6. Verfahren nach Anspruch 5, dadurch gekennzeichnet, dass der Verfahrensschritt a) folgende Schritte umfasst :

— Aufbringen einer Siliziumnitridschicht (40) auf die Platte ;

— Oeffnen dieser Nitridschicht (40) an denjenigen Stellen, an welchen die Rillen erzeugt werden sollen ;

— Aetzen der Platte vermittels einer anisotropen Aetzsubstanz ;

— Durchführung einer Wärmebehandlung zwecks Oxydierung der sichtbaren Oberfläche der Rillen.

7. Verfahren nach einem der Ansprüche 5 oder 6, dadurch gekennzeichnet, dass man vor dem Verfahrensschritt a) in der Platte einen diffundierten Schutzring (22) bildet, der den MOS-Transistor umgibt, welcher vom dem Typ der Platte entgegengesetzten Typ ist, wobei dieser Schutzring (22) an seinem äusseren Umfang teilweise mit einer Siliziumoxydschicht (40) bedeckt ist, und dass bei Durchführung des Verfahrensschritts b) auf der ringförmigen Siliziumoxydschicht eine polykristalline Siliziumschicht erzeugt wird und man gleichzeitig eine polykristalline Siliziumgitterschicht über den Rillen herstellt, derart, dass die beiden polykristallinen Siliziumschichten mit einander in Verbindung stehen.

8. Verfahren nach Anspruch 6, dadurch gekennzeichnet, dass der Metallisations-Verfahrensschritt d) die folgenden Schritte umfasst :

— Aufbringen einer einheitlichen Siliziumnitridschicht (50) ;

— Umwandlung in Silizium durch Anodisieren der dünnsten Teile der Nitridschicht (50), die unmittelbar auf denjenigen Stellen der Platte aufgebracht sind, an welchen der Halbleiter vor dem Aufbringen des Nitrids entblösst war ;

— Entfernen des Siliziumoxyds durch chemisches Aetzen ;

— Aufbringen einer Metallisationsschicht.

## FIG_1

## FIG_2

FIG_3

33
34
24
23
22
P
27
26
N+
25
31
32
30
N+
N+
34
30
N
N+
35
24
34
21
20

2

0 026 686

FIG_4

FIG_5

FIG_6

FIG_7

FIG_8

# FIG_9

44
24
32
23
22
25
31

# FIG_10

45
24
46
26
32
23
27
25
31
22

# FIG_11

34
34

# FIG_12

33
N+ N+ N+ N+ N+ N+
P P P
N

FIG_13

FIG_14

FIG_15

FIG_16

# FIG_17

# FIG_18

# FIG_19